# EUROPEAN PATENT APPLICATION

(11) **EP 4 600 403 A1**
(43) Date of publication of application: **13.08.2025**
(21) Application number: 24805409.0
(22) Date of filing: 23.10.2024
(51) Int. Cl.: C23C 16/513, C23C 16/50, H01J 37/32

(54) **ELECTRODE ASSEMBLY AND PLASMA-ENHANCED CHEMICAL VAPOR DEPOSITION DEVICE**

(30) Priority: 07.12.2023 CN 202323330130 U
(71) Applicant: Yingkou Jinchen Machinery Co., Ltd., Yingkou, Liaoning 115000 (CN)
(72) Inventor: WANG, Yuming, Yingkou, Liaoning 115000 (CN); ZHOU, Yulong, Yingkou, Liaoning 115000 (CN); CHENG, Hailiang, Yingkou, Liaoning 115000 (CN); YANG, Baohai, Yingkou, Liaoning 115000 (CN)
(74) Representative: Herrero & Asociados, S.L.
(86) International application number: PCT/CN2024/126729
(87) International publication number: WO 2025/118851

(57) **Abstract**

Embodiments of the present application relate to an electrode assembly and a plasma enhanced chemical vapor deposition equipment, comprising an electrode rod, an adjusting sleeve, a fixing sleeve and a regulating assembly. The adjusting sleeve is configured to fix the electrode rod. The fixing sleeve is configured to be connected to a tail electrode flange. The adjusting sleeve is connected to the electrode rod and positioned coaxially with the electrode rod. The fixing sleeve is provided with an adjusting hole along an axis of the fixing sleeve. The adjusting sleeve is installed within the adjusting hole. The regulating assembly is configured to regulate a coaxiality of the adjusting sleeve with respect to the fixing sleeve.

## Description

### CROSS-REFERENCE TO RELATED APPLICATION

This application claims the priority of the Chinese patent application No. 202323330130.5, filed on December 07, 2023, and entitled "ELECTRODE ASSEMBLY AND PLASMA ENHANCED CHEMICAL VAPOR DEPOSITION EQUIPMENT", the content of which is incorporated herein by reference in its entirety.

### TECHNICAL FIELD

Embodiments of the present application relate to the technical field of equipment for manufacturing the photovoltaic cell, and in particular to an electrode assembly and a plasma enhanced chemical vapor deposition equipment.

### BACKGROUND

Plasma Enhance Chemical Vapour Deposition (PECVD) technology uses low-temperature plasma to generate a glow discharge between the cathode and anode in a process chamber under low pressure. A part of process gas undergoes a series of chemical reactions and plasma reactions due to the glow discharge, and finally forms a solid film on surfaces of a sample. The PE-Poly technology is able to realize "three-in-one" preparation of a silicon oxide tunneling layer, an amorphous silicon layer as the precursor of poly-silicon (named as Poly) layer, and in-situ doping in the amorphous silicon layer by means of a plasma enhanced chemical vapor deposition technology. As an application of above technology, the plasma enhanced chemical vapor deposition equipment plays an important role. During the implementation of the process, the plasma enhanced chemical vapor deposition equipment transfers electrical power from an external power supply to a graphite boat through an electrode assembly. Generally, the electrode assembly is installed to a tail electrode flange. When the graphite boat is installed within the equipment, an electrode head at an end of the electrode assembly is engaged into a corresponding electrode hole of the graphite boat.

### SUMMARY

In order to overcome disadvantages of the related art described above, embodiments of the present application provide an electrode assembly and a plasma enhanced chemical vapor deposition equipment, specific technical solutions of which are as follows:

An electrode assembly comprises an electrode rod, an adjusting sleeve 7, a fixing sleeve 9 and a regulating assembly. The adjusting sleeve 7 is configured to fix the electrode rod, and the fixing sleeve 9 is configured to be connected to a tail electrode flange. The adjusting sleeve is connected to the electrode rod and positioned coaxially with the electrode rod. The fixing sleeve is provided with an adjusting hole along an axis of the fixing sleeve. The adjusting sleeve is installed within the adjusting hole. The regulating assembly is configured to regulate a coaxiality of the adjusting sleeve with respect to the fixing sleeve.

In some embodiments of the present application, the adjusting sleeve comprises a fixing boss and an extending sleeve which is coaxially fixed to the electrode rod. One end of the extending sleeve is connected to the fixing boss, and another end of the extending sleeve extends into the adjusting hole. A diameter of a portion of the extending sleeve positioned within the adjusting hole is smaller than a diameter of the adjusting hole.

In some embodiments of the present application, the regulating assembly comprises a first adjusting block and a second adjusting block. The first adjusting block is mounted around the electrode rod. The second adjusting block is positioned between the first adjusting block and the adjusting sleeve, and is mounted around the electrode rod.

In some embodiments of the present application, an end surface of the first adjusting block facing the adjusting sleeve is provided with a first groove. The second adjusting block is engaged into the first groove. An end surface of the second adjusting block facing the adjusting sleeve is provided with a second groove. The adjusting sleeve is engaged into the second groove.

In some embodiments of the present application, an electrode body is provided on an end of the electrode rod. The electrode body is configured to electrically connect the electrode rod to an external power supply. The electrode body is connected to an end surface of the first adjusting block. An end surface of the electrode body facing the electrode rod is provided with an extending shaft which is provided with a connecting hole along an axis of the extending shaft. An end of the electrode rod is fixedly connected to the connecting hole.

In some embodiments of the present application, an insulating sleeve is provided on an outer peripheral face of the extending shaft. The insulating sleeve is configured to keep the first adjusting block electrically insulated from the electrode rod and insulate a thermal transmission.

In some embodiments of the present application, a conical sealing surface is provided on an edge of the adjusting hole facing the adjusting sleeve. A first sealing ring is provided on the conical sealing surface and is configured to seal a gap between the adjusting hole and the adjusting sleeve.

In some embodiments of the present application, a second sealing ring is provided between the first groove and an end surface of the second adjusting block. The second sealing ring is configured to seal a gap between the first adjusting block and the second adjusting block. A third sealing ring is provided between the second groove and the adjusting sleeve. The third sealing ring is configured to seal a gap between the second adjusting block and the adjusting sleeve.

In some embodiments of the present application, the regulating assembly further comprises a plurality of fasteners. A plurality of through holes is circumferentially distributed on an inner side of the first adjusting block. Each of the through holes corresponds to a respective one of the fasteners. An end of the respective fastener passes through the respective through hole to connect to the fixing sleeve. The coaxiality of the adjusting sleeve with respect to the fixing sleeve is changeable by tightening or loosening the fasteners at different positions.

In addition, embodiments of the present application provide a plasma enhanced chemical vapor deposition equipment comprising a tail electrode flange. The electrode assembly as described above is connected to the tail electrode flange.

In the electrode assembly and the plasma enhanced chemical vapor deposition equipment according to embodiments of the present application, the coaxiality of the adjusting sleeve with respect to the fixing sleeve can be controlled through the regulating assembly, so as to regulate a coaxiality of the electrode assembly with respect to the electrode hole of the graphite boat. In this way, it is ensured that the electrode assembly is accurately inserted into the electrode hole of the graphite boat.

### BRIEF DESCRIPTION OF THE DRAWINGS

In order to more clearly explain technical solutions in embodiments of the present application or in the related art, drawings used for the description of DETAILED DESCRIPTION section and related art will be briefly described below. Drawings described herein are incorporated into the Description and constitute a portion of the Description. These drawings illustrate embodiments according to the present application, and are used to explain the technical solutions of the present application along with the Description. Obviously, the drawings described below merely illustrate some implementations of embodiments of the present application. Other drawings can be obtained by those skilled in the art based on these drawings without creative labor.
FIG. 1 is a schematic view of assembling of an electrode assembly in an embodiment of the present application.
FIG. 2 is a front cross section schematic view of the electrode assembly in an embodiment of the present application.
FIG. 3 is an enlarged schematic view of the electrode assembly in an embodiment of the present application.
FIG. 4 is a lateral schematic view of the electrode assembly in an embodiment of the present application.
FIG. 5 is a schematic view of a fixing sleeve in an embodiment of the present application.
FIG. 6 is a schematic view of assembling of the electrode assembly and a tail electrode flange in an embodiment of the present application.

### List of Reference Signs:

1-electrode body; 101-extending shaft; 102-connecting hole; 2-first adjusting block; 201-through hole; 202-first groove; 3-insulating sleeve; 4-second sealing ring; 5-second adjusting block; 501-second groove; 6-third sealing ring; 7-adjusting sleeve; 701-extending sleeve; 702-fixing boss; 8-first sealing ring; 9-fixing sleeve; 901-adjusting hole; 902-conical sealing surface; 903-annular flange; 10-fourth sealing ring; 11-electrode rod; 12-electrode head; 13-fastener; 14-tail electrode flange; 15-rectangular fixing plate; 16-connecting screw.

### DETAILED DESCRIPTION

The present application is further described below with reference to the drawings. The following embodiments are merely intended to more clearly describe the technical solutions of the embodiments of the present application, and should not be interpreted to limit the scope of protection of the present application. It should be noted that the following detailed description is exemplary and is intended to further illustrate the present application.

In the description of the embodiments of the present application, it should be understood that the orientation or positional relationship indicated by the terms "center", "above", "under", "front", "behind", "left", "right", "vertical", "horizontal", "top", "bottom", "inner" or "outer" etc. is based on the orientation or positional relationship shown in the drawings, merely for the convenience of describing the embodiments of the present application and for simplification of the description, and does not indicate or imply that the referred device or element has a specific orientation, is configured and operated in a specific orientation. Therefore above orientation or positional relationship cannot be understood as a limitation of the embodiments of the present application.

The terms "first" and "second" are merely for description and should not be understood as indicating or implying relative importance or as implicitly indicating the number of technical features referred. Thus, a feature defined by "first" or "second" may explicitly or implicitly comprises one or more features. In the description of embodiments of the present application, unless specified otherwise, "a plurality" or "several" means two or more.

In the description of the embodiments of the present application, it should be noted that unless explicitly specified and limited otherwise, the terms "mount", "connect", and "link" should be understood in a broad sense. For example, each of above terms may mean fixed connection, detachably connection, or integral connection, may mean mechanical connection or electrical connection, or may mean direct connection, indirect connection through an intermediate medium, or communication of the inner parts of two elements. Those skilled in the art would understand the specific meanings of above terms in the embodiments of the present application according to specific situations.

At present, each time a process has been completed, a graphite boat within a plasma enhanced chemical vapor deposition equipment needs to be replaced. However, since there may be the installation error during the replacement of the graphite boat, and an installation position for an electrode assembly is relatively fixed, it may result in that an electrode hole of the graphite boat is offset with respect to the electrode assembly. In this case, the electrode assembly cannot align with the electrode hole of the graphite boat. Due to the misalignment of the electrode assembly with respect to the electrode hole, during the graphite boat is pushed into the equipment, other parts of the graphite boat may collide with the electrode assembly, which will cause the deformation of the electrode assembly or damage to the graphite boat. Therefore, in order to avoid the misalignment of the electrode assembly with respect to the electrode hole of the graphite boat, it is necessary to provide an adjustable electrode assembly. That is, during the process of installing the electrode assembly to a tail electrode flange, a coaxiality of the electrode assembly with respect to the tail electrode flange is adjustable, such that during the graphite boat is pushed into the equipment, the electrode assembly can be adjusted to align with the electrode hole of the graphite boat. Therefore, a possibility of misalignment of the electrode assembly with respect to the electrode hole and the impact risk can be reduced.

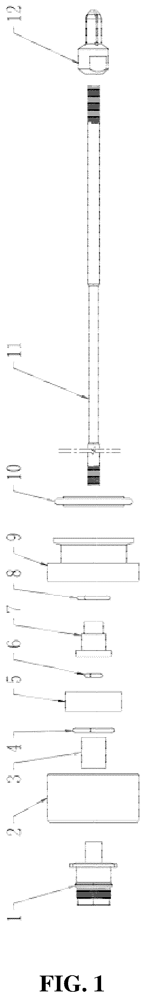

In some embodiments of the present application, as shown in FIGS. 1-6, an embodiment of the present application provides an electrode assembly comprising an electrode rod 11, an adjusting sleeve 7, a fixing sleeve 9 and a regulating assembly. The adjusting sleeve 7 is configured to fix the electrode rod. The fixing sleeve 9 is configured to be connected to a tail electrode flange 14.

Specifically, in an embodiment of the present application, the adjusting sleeve 7 is connected to the electrode rod 11 and positioned coaxially with the electrode rod 11. The fixing sleeve 9 is provided with an adjusting hole 901 along an axis of the fixing sleeve, and the adjusting sleeve 7 is installed within the adjusting hole 901. The regulating assembly is configured to regulate a coaxiality of the adjusting sleeve 7 with respect to the fixing sleeve 9.

According to the technical solution of an embodiment of the present application, the coaxiality of the adjusting sleeve 7 with respect to the fixing sleeve 9 can be controlled by the regulating assembly, so as to regulate a coaxiality of an electrode head 12 connected to an end of the electrode rod 11 with respect to an electrode hole of a graphite boat. In this way, it is ensured that the electrode assembly is accurately inserted into the electrode hole of the graphite boat.

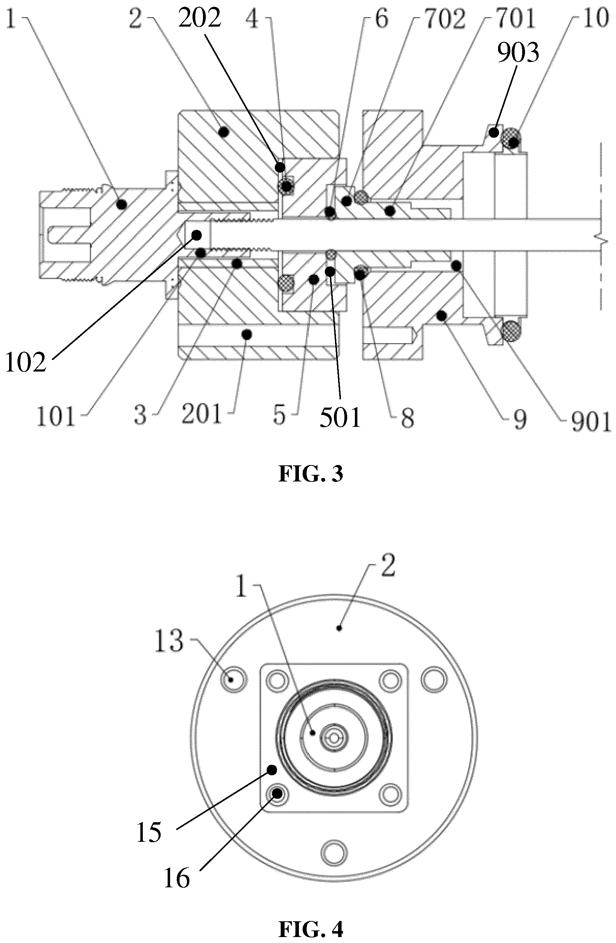

In some embodiments of the present application, with reference to FIG. 3, the adjusting sleeve 7 comprises a fixing boss 702, and an extending sleeve 701 which is fixed to the electrode rod 11 and is positioned coaxially with the electrode rod 11. One end of the extending sleeve 701 is connected to the fixing boss 702, and another end of the extending sleeve 701 extends into the adjusting hole 901. A diameter of a portion of the extending sleeve 701 positioned within the adjusting hole 901 is smaller than a diameter of the adjusting hole 901.

According to the technical solution of an embodiment of the present application, a diameter of a portion of the adjusting sleeve 7 is smaller than the diameter of the adjusting hole 901 of the fixing sleeve 9, that is, the diameter of the portion the extending sleeve 701 of the adjusting sleeve 7 positioned within the adjusting hole 901 is smaller than the diameter of the adjusting hole 901. Therefore, there is a space allowing for the adjusting sleeve 7 to move with respect to the adjusting hole 901, that is, the adjusting sleeve 7 can displace with respect to the fixing sleeve 9 along a radial direction. Thus the adjusting sleeve 7 is able to regulate the its coaxiality with respect to the fixing sleeve 9 within a predetermined range, so that a relative position of the electrode assembly extending into the tail electrode flange 14 with respect to the tail electrode flange can be changed.

In an embodiment of the present application, the fixing sleeve 9 is configured to be connected to the tail electrode flange 14 of a plasma enhanced chemical vapor deposition equipment. One end surface of the fixing sleeve 9 is provided with an annular flange 903 with a rectangular trapezoidal cross section. A fourth sealing ring 10 is sandwiched between the annular flange 903 and the tail electrode flange 14. The annular flange 903 and the tail electrode flange 14 are fixed by a KF40 clamp. When the KF40 clamp is tightened, the annular flange 903 is clamped against the tail electrode flange 14. The fourth sealing ring 10 can improve sealability between the fixing sleeve 9 and the tail electrode flange 14.

In some embodiments of the present application, with reference to FIG. 3, the regulating assembly comprises a first adjusting block 2 and a second adjusting block 5. The first adjusting block 2 is mounted around the electrode rod 11. The second adjusting block 5 is positioned between the first adjusting block 2 and the adjusting sleeve 7, and is mounted around the electrode rod 11.

According to the technical solution of an embodiment of the present application, the connection and fixation of the adjusting sleeve 7 can be achieved by the first adjusting block 2 and the second adjusting block 5, so as to improve the stability of the connection of the adjusting sleeve 7 to the electrode rod 11.

In some embodiments of the present application, with reference to FIG. 3, an end surface of the first adjusting block 2 facing the adjusting sleeve 7 is provided with a first groove 202, and the second adjusting block 5 is engaged into the first groove 202. An end surface of the second adjusting block 5 facing the adjusting sleeve 7 is provided with a second groove 501, and the adjusting sleeve 7 is engaged into the second groove 501.

According to the technical solution of an embodiment of the present application, the first adjusting block 2 and the second adjusting block 5 are configured to connect and fix the adjusting sleeve 7. Through the engagement of the first adjusting block 2, the second adjusting block 5, and the adjusting sleeve 7, it is possible to realize connection and fixation of above three elements, and reduce the volume of the regulating assembly assembled.

In some embodiments of the present application, with reference to FIGS. 3 and 4, the regulating assembly further comprises a plurality of fasteners 13. A plurality of through holes 201 are circumferentially distributed on an inner side of the first adjusting block. Each of the through holes 201 corresponds to a respective one of the fasteners 13. An end of the respective fastener 13 passes through the respective through hole 201 to connect to the fixing sleeve 9. The coaxiality of the adjusting sleeve 7 with respect to the fixing sleeve 9 can be changed by tightening or loosening the fasteners 13 at different positions.

According to the technical solution of an embodiment of the present application, on the one hand, the fasteners 13 can assemble and fix the first adjusting block 2, the fixing sleeve 9 and components between them; on the other hand, a gap distance between the first adjusting block 2 and the fixing sleeve 9 can be adjusted by mean of the fastener 13 distributed on the first adjusting block 2, such that a coaxiality of the electrode rod 11 can be changed. That is, the coaxiality of the adjusting sleeve 7 with respect to the fixing sleeve 9 can be controlled, so as to realize position calibration of the electrode assembly. In the case that the electrode assembly is assembled on the tail electrode flange 14, by screwing the fasteners 13 at different positions, assembly errors of parts can be overcome, and the coaxiality of the electrode rod 11 with respect to the electrode hole of the graphite boat can be improved, which reduces the possibility of collision between the electrode rod and the graphite boat.

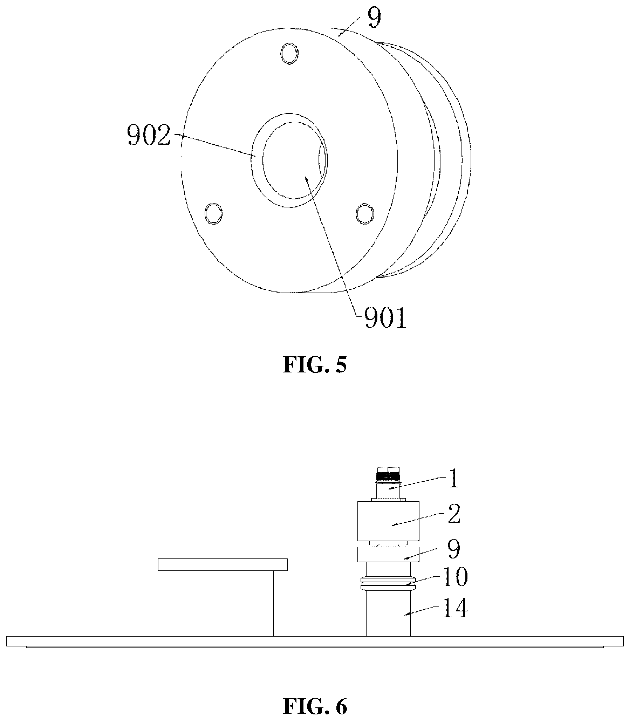

In some embodiments of the present application, with reference to FIGS. 3 and 5, in order to improve performance of an inner vacuum chamber of the equipment, a conical sealing surface 902 is provided on an edge of the adjusting hole 901 facing the adjusting sleeve 7. A first sealing ring 8 is provided on the conical sealing surface 902 and is configured to seal a gap between the adjusting hole 901 and the adjusting sleeve 7.

According to the technical solution of an embodiment of the present application, sealability between the adjusting sleeve 7 and the fixing sleeve 9 can be improved by the first sealing ring 8, so as to reduce a possibility of external gas entering into an interior of the equipment through the electrode assembly.

In some embodiments of the present application, with reference to FIG. 3, a second sealing ring 4 is provided between the first groove 202 and an end surface of the second adjusting block 5. The second sealing ring 4 is configured to seal a gap between the first adjusting block 2 and the second adjusting block 5. A third sealing ring 6 is provided between the second groove 501 and the adjusting sleeve 7. The third sealing ring 6 is configured to seal a gap between the second adjusting block 5 and the adjusting sleeve 7.

According to the technical solution of an embodiment of the present application, radial sealing performance and axial sealing performance of the electrode rod 11 can be improved by the above sealing rings (the first sealing ring 8, the second sealing ring 4 and third sealing ring 6), so as to improve vacuum performance of the equipment. Specifically, the second sealing ring 4 and the third sealing ring 6 isolate an interior of the electrode assembly from the external environment. Thus it is difficult for external gas to enter into the interior of the equipment through the electrode assembly, thereby improving a vacuum performance of the interior of the equipment.

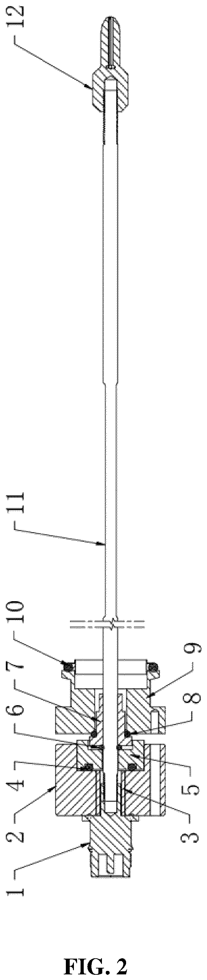

In some embodiments of the present application, with reference to FIGS. 2 and 3, an electrode body 1 is provided on an end of the electrode rod 11, and is configured to electrically connect the electrode rod 11 to an external power supply. The electrode head 12 is provided on another end of the electrode rod 11, and is configured to fitted into the electrode hole of the graphite boat. The electrode body 1 is connected to an end surface of the first adjusting block 2. As shown in FIG. 4, a rectangular fixing plate 15 extending radially is provided at an edge of an end surface of the electrode body 1. Each of four corner portions of the rectangular fixing plate 15 is provided with a connecting screw 16, which fixes the electrode body 1 onto the first adjusting block 2. An end surface of the electrode body 1 facing the electrode rod 11 is provided with an extending shaft 101 which is provided with a connecting hole 102 along an axis of the extending shaft. An end of the electrode rod 11 is fixedly connected to the connecting hole 102.

According to the technical solution of an embodiment of the present application, electrical power can be transferred from the external power supply to the electrode rod 11 through the electrode body 1, and be transferred to the graphite boat through the electrode head 12 on the end of the electrode rod 11, so as to supply power to the graphite boat.

In some embodiments of the present application, with reference to FIGS. 1, 2 and 3, in order to reduce a possibility of the electric leakage to an outer portion of the electrode assembly, an insulating sleeve 3 is provided on an outer peripheral face of the extending shaft 101. The insulating sleeve 3 is arranged between the first adjusting sleeve 2 and the electrode rod 11, which can reduce a possibility of the electric leakage to the first adjusting block 2, thereby reducing a risk of electric shock. Furthermore, the electrode rod 11 may conducts heat during operation. To prevent an overall overheating of the electrode assembly, a thermal transmission can be insulated by the insulating sleeve 3.

It should be noted that, in order to prevent the electric leakage of the plasma enhanced chemical vapor deposition equipment during discharging of the electrode rod 11, the adjusting sleeve 7 is also made of material that is high-temperature resistant and electrically insulating. Optionally, in an embodiment of the present application, the material that is high-temperature resistant and electrically insulating is ceramic. Thus electrical power cannot be conducted to an outer surface of the electrode assembly during discharging of the electrode rod 11, thereby improving the safety of the equipment.

In some embodiments of the present application, with reference to FIG. 6, the plasma enhanced chemical vapor deposition equipment comprises a tail electrode flange 14. The electrode assembly according to embodiments of the present application is connected to the tail electrode flange 14.

It should be noted that, as shown in FIG. 6, the electrode assembly according to embodiments of the present application is configured to be used in a plasma enhanced chemical vapor deposition equipment. The electrode assembly is connected to the tail electrode flange 14 of the plasma enhanced chemical vapor deposition equipment by means of the KF40 clamp. Compared with a traditional screw fastening manner, the use of the KF40 clamp allows a fast and convenient disassembly and assembly of the sealing ring so as to reduce the maintenance time.

Above descriptions are merely preferred implementations of embodiments of the present application. It should be noted that for those skilled in the art, improvements and modifications can be made without departing from the technical principles of embodiments of the present application, and these improvements and modifications should also be regarded as falling within the scope of protection of embodiments of the present application.

## Claims

1. An electrode assembly, comprising an electrode rod (11), an adjusting sleeve (7), a fixing sleeve (9) and a regulating assembly, the adjusting sleeve (7) being configured to fix the electrode rod (11), the fixing sleeve (9) being configured to be connected to a tail electrode flange (14);
the adjusting sleeve (7) is connected to the electrode rod (11) and positioned coaxially with respect to the electrode rod (11), the fixing sleeve (9) being provided with an adjusting hole (901) along an axis of the fixing sleeve, the adjusting sleeve (7) being installed within the adjusting hole (901), the regulating assembly being configured to regulate a coaxiality of the adjusting sleeve (7) with respect to the fixing sleeve (9).

2. The electrode assembly according to claim 1, wherein the adjusting sleeve (7) comprises a fixing platform (702) and an extending sleeve (701) which is coaxially fixed to the electrode rod (11), one end of the extending sleeve (701) being connected to the fixing platform (702), and another end of the extending sleeve (701) extending into the adjusting hole (901), a diameter of a portion of the extending sleeve (701) positioned within the adjusting hole (901) being smaller than a diameter of the adjusting hole (901).

3. The electrode assembly according to claim 1 or 2, wherein the regulating assembly comprises a first adjusting block (2) and a second adjusting block (5), the first adjusting block (2) being mounted around the electrode rod (11), the second adjusting block (5) being positioned between the first adjusting block (2) and the adjusting sleeve (7), and being mounted around the electrode rod (11).

4. The electrode assembly according to claim 3, wherein an end surface of the first adjusting block (2) facing the adjusting sleeve (7) is provided with a first groove (202), the second adjusting block (5) being engaged into the first groove (202), an end surface of the second adjusting block (5) facing the adjusting sleeve (7) being provided with a second groove (501), the adjusting sleeve (7) being engaged into the second groove (501).

5. The electrode assembly according to claim 3 or 4, wherein an electrode body (1) is provided on an end of the electrode rod (11), the electrode body (1) being configured to electrically connect the electrode rod (11) to an external power supply, the electrode body (1) being connected to an end surface of the first adjusting block (2), an end surface of the electrode body (1) facing the electrode rod (11) being provided with an extending shaft (101) which is provided with a connecting hole (102), an end of the electrode rod (11) being fixedly connected to the connecting hole (102).

6. The electrode assembly according to claim 5, wherein an insulating sleeve (3) is provided on an outer peripheral face of the extending shaft (101), the insulating sleeve (3) being configured to keep the first adjusting block (2) electrically insulated from the electrode rod (11) and insulate a thermal transmission.

7. The electrode assembly according to claim 2, wherein a conical sealing surface (902) is provided on an edge of the adjusting hole (901) facing the adjusting sleeve (7), a first sealing ring (8) being provided on the conical sealing surface (902) and being configured to seal a gap between the adjusting hole (901) and the adjusting sleeve (7).

8. The electrode assembly according to claim 4, wherein a second sealing ring (4) is provided between the first groove (202) and an end surface of the second adjusting block (5), the second sealing ring (4) being configured to seal a gap between the first adjusting block (2) and the second adjusting block (5), a third sealing ring (6) being provided between the second groove (501) and the adjusting sleeve (7), the third sealing ring (6) being configured to seal a gap between the second adjusting block (5) and the adjusting sleeve (7).

9. The electrode assembly according to any one of claims 3 to 6, wherein the regulating assembly further comprises a plurality of fasteners (13), a plurality of through holes (201) being circumferentially distributed on an inner side of the first adjusting block (2), each of the through holes (201) corresponding to a respective one of the fasteners (13), an end of the respective fastener (13) passing through the respective through hole (201) and being connected to the fixing sleeve (9), the coaxiality of the adjusting sleeve (7) with respect to the fixing sleeve (9) being changeable by tightening or loosening the fasteners (13) at different positions.

10. A plasma enhanced chemical vapor deposition equipment comprising a tail electrode flange (14), **characterized in that** an electrode assembly according to any one of claims 1 to 9 is connected to the tail electrode flange (14).
